# EUROPÄISCHE PATENTSCHRIFT

(11) **EP 1 298 845 B1**
(45) Veröffentlichungstag und Bekanntmachung des Hinweises auf die Patenterteilung: **23.11.2005**
(21) Anmeldenummer: 02020969.8
(22) Anmeldetag: 19.09.2002
(51) Int. Cl.: H04L 12/28, H02J 13/00, H02G 3/00

(54) **Installationsgerät**
Installationapparatus
Appareil d'installation

(30) Priorität: 28.09.2001 DE 10147944
(43) Veröffentlichungstag der Anmeldung: 02.04.2003
(73) Patentinhaber: SIEMENS AKTIENGESELLSCHAFT, 80333 München (DE)
(72) Erfinder: Gerlach, Horst, Dr., 93073 Neutraubling (DE)

(56) Entgegenhaltungen:
- EP-A- 0 759 651
- EP-A- 0 772 132
- EP-A- 0 880 209
- DE-C- 4 311 096
- DE-U- 29 504 491

## Beschreibung

Die Erfindung betrifft ein (digitales) Installationsgerät gemäß dem Oberbegriff des Anspruchs 1. Ein derartiges Installationsgerät mit einem Unterputzmodul als Aktor in der Ausführung als Schaltaktor oder Dimmaktor ist z. B. aus der EP 0 759 651 A2 bekannt.

Aus der DE 295 04 491 U1 ist ein Installationsgerät bekannt, bei dem eine Baueinheit aus einem Busankoppler und einem funktionsbestimmten Teil einteilig ausgebildet ist. Dabei ist der funktionsbestimmte Teil ein Taster mit drei Stellungen, ein sogenannter Dreistellungstaster.

Busfähige, digitale Installationsgeräte werden üblicherweise in einem digitalen Übertragungssystem, z. B. in der Gebäudesystemtechnik oder in der Automatisierungstechnik eingesetzt. Gebräuchlich ist beispielsweise der von der European Installation Bus Association (EIBA) konzipierte europäische Installationsbus EIB. Über den europäischen Installationsbus EIB können unter anderem Heizungen, Lüftungen, Klimasteuerungen und Beleuchtungseinrichtungen gesteuert werden. Bedienelemente für den EIB sind insbesondere Sensoren, wie z. B. Temperaturfühler, Helligkeitssensoren oder manuell bedienbare Schalter.

Aus der DE 297 01 136 U1 ist es bekannt, ein auch als Anwendungsmodul bezeichnetes Bedienelement auf einen Busankoppler aufzustecken. Der Busankoppler kann hierbei als Unterputz-Busankoppler ausgeführt sein.

Des Weiteren ist aus der DE 199 12 429 A1 ein Koppelelement zur Installation in einer Unterputzdose bekannt, das zur Verwendung in einem digitalen Signalübertragungssystem der Gebäudesystemtechnik vorgesehen ist. An das Koppelelement kann außerhalb der Unterputzdose über eine Schnittstelle ein Applikationsmodul für einen Satz von Anwenderfunktionen angeschlossen werden. Ebenfalls außerhalb der Unterputzdose kann das Applikationsmodul über ein Anwendungsgerät mit einem Endgerät verbunden sein.

Ferner ist z. B. aus der DE 40 13 491 A1 eine Einrichtung zum Ankoppeln von Schaltern, Tastern und dgl. an ein drahtgebundenes Bussystem bekannt. Die bekannte Einrichtung umfasst eine Schnittstelle, die als Wandschnittstelle ausgebildet und in einer konventionellen Standardunterputzdose untergebracht ist. Der Einbau der direkt unterhalb eines konventionellen Tasters oder Schalters angeordneten Schnittstelle, die über Verbindungsleitungen an diesen Taster oder diesen Schalter angeschlossen ist, in eine Standardunterputzdose führt jedoch zu unerwünscht beengten Einbauverhältnisse.

Der Erfindung liegt die Aufgabe zugrunde, ein einfach montierbares, raumsparendes Installationsgerät mit einem Busankoppler zum Anschluss an einen Installationsbus, insbesondere der Gebäudesystemtechnik, anzugeben.

Diese Aufgabe wird erfindungsgemäß gelöst durch die Merkmale des Anspruchs 1. Hierbei wird ein Busankoppler eines Installationsgerätes mit einem Bedienelement zu einem als zweiseitig bestückte Leiterplatte ausgeführten Kompaktmodul zusammengefasst, das zusätzlich eine erste Schnittstelle zu einem Installationsbus und eine zweite Schnittstelle zu einem Unterputzmodul aufweist. Hierbei weist eine erste Seite der Leiterplatte ein Bauteil des Bedienelements und eine zweite Seite der Leiterplatte ein Bauteil des Busankoppplers auf. Damit ist eine besonders raumsparende Bauform gegeben.

Dieses Kompaktmodul erfordert beim Einbau des Installationsgerätes in eine Unterputzdose keinerlei Verdrahtungsarbeiten zwischen Busankoppler und Bedienelement. Anstelle einer Unterputzdose kann auch ein sonstiges enges Behältnis für den Einbau des Installationsgerätes vorgesehen sein. Im Folgenden wird eine Unterputzdose oder ein sonstiges enges Behältnis zusammenfassend als Gehäuse bezeichnet. Durch die kompakte Bauweise des Installationsgerätes wird einerseits ein einfacher Einbau in das Gehäuse ermöglicht. Andererseits sind auch günstige Bedingungen für eine gute Wärmeabfuhr sichergestellt.

Das Installationsgerät weist je eine Schnittstelle zu einem Installationsbus, insbesondere zu einem Bus der Gebäudesystemtechnik, vorzugsweise zum EIB, und zu einem Unterputzmodul auf. Über die Schnittstelle zum Installationsbus kann der Busankoppler vorzugsweise bidirektional Daten senden beziehungsweise empfangen.

Das Unterputzmodul wird in vorteilhafter Ausführung als Lastaktor oder als Lastmodul zum Schalten eines externen Lastaktors ausgeführt oder weist einen solchen Lastaktor beziehungsweise ein solches Lastmodul auf.

In einer weiteren bevorzugten Ausführung weist das Unterputzmodul einen Binäreingang auf. Die Schnittstelle des Kompaktmoduls zum Unterputzmodul ist vorteilhafterweise standardisiert.

Zusätzlich können auf der Bedienelementseite der Leiterplatte auch mechanische und/oder elektromechanische Bauteile, z. B. Taster, befestigt sein.

Die mit der Erfindung erzielten Vorteile bestehen insbesondere darin, dass durch die Zusammenfassung eines je eine Schnittstelle zu einem Installationsbus und zu einem Unterputzmodul aufweisenden Busankopplers mit einem Bedienelement zu einem Kompaktmodul eine besonders raumsparende und installationsfreundliche Ausführung eines zum Einbau in ein Gehäuse, insbe-sondere in eine Unterputzdose, geeigneten Installationsgerätes für ein digitales Übertragungssystem, insbesondere in der Gebäudesystemtechnik, erreicht wird.

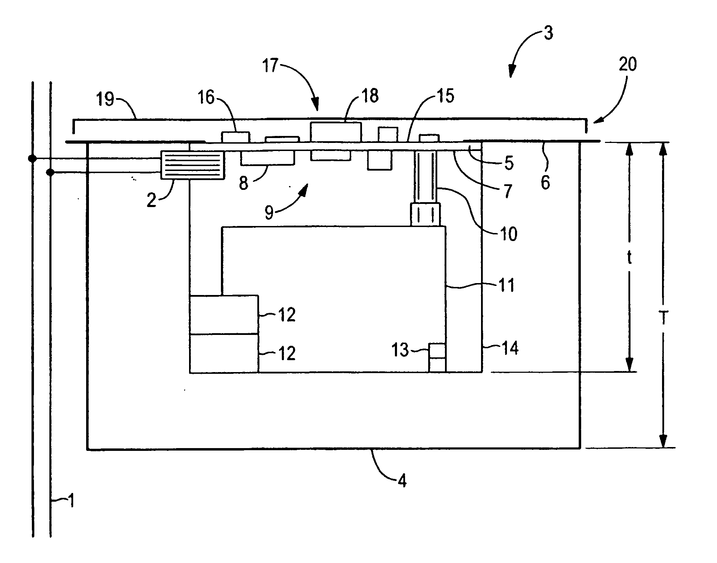

Nachfolgend wird ein Ausführungsbeispiel der Erfindung anhand einer Zeichnung näher erläutert. Dabei zeigt die einzige Figur schematisch ein Installationsgerät mit einem Busankoppler und einem Bedienelement sowie einem Unterputzmodul in einem Gehäuse.

In der Figur ist ein an einen Installationsbus 1, der Teil eines digitalen Übertragungssystems ist, über eine Schnittstelle 2 angeschlossenes Installationsgerät 3 dargestellt, das in ein Gehäuse 4 eingebaut ist. Dies kann insbesondere als Unterputzdose ausgeführt sein. Zwischen dem Installationsgerät 3 und dem übergeordneten digitalen Übertragungssystem besteht eine bidirektionale Verbindung über leitungsgebundene Übertragungswege, wie z. B. den dargestellten Installationsbus 1 und/oder über Funk.

Das Installationsgerät 3 umfasst eine Leiterplatte 5, die an einem Installationsrahmen 6 anliegt. Auf der in das Gehäuse 4 weisenden Unterseite 7 der Leiterplatte 5 sind Bauteile 8 eines Busankopplers 9 angeordnet. Des Weiteren ist auf der Unterseite 7 der Leiterplatte 5 die Schnittstelle 2 sowie eine Schnittstelle 10 zu einem Unterputzmodul 11 angeordnet, das zwei Relais als Lastaktoren 12 sowie einen Binäreingang 13 aufweist. Über den Binäreingang 13 kann beispielsweise eine Information über den Schaltzustand eines (nicht dargestellten) an den Installationsbus 1 angeschlossenen Gerätes an das Installationsgerät 3 übertragen werden.

Der Busankoppler 9 und das Unterputzmodul 11 sind in einem Gehäuse 14 zusammengefasst, dessen Tiefe t mit beispielsweise 32 mm wesentlich geringer als die Tiefe T des Gehäuses 4 ist. Anstelle des Gehäuses 14 kann auch in nicht näher dargestellter Art und Weise eine offene Stützkonstruktion vorgesehen sein, durch die aufgrund einer ungehinderten Luftzirkulation innerhalb des Gehäuses 4 eine besonders gute Wärmeabfuhr der wärmeerzeugenden Einbauten 9, 11 gewährleistet ist.

Auf der Oberseite oder Bedienelementseite 15 der Leiterplatte 5 sind elektronische Bauteile 16 eines Bedienelementes 17 sowie ein mechanisches Koppelelement 18 angeordnet. Das mechanische Koppelelement 18 trägt eine manuell zu betätigende Wippe 19 als weiteres Teil des Bedienelementes 17. Zusätzlich oder alternativ können auf der Oberseite 15 der Leiterplatte 5 mechanische und/oder elektromechanische Bauteile, z. B. Taster, angeordnet sein, die auch von einer zusätzlichen (nicht dargestellten) Stützkonstruktion unterstützt werden können. Durchkontaktierungen durch die Leiterplatte 5 zum Busankoppler 9 sind vorgesehen, jedoch nicht dargestellt.

Das auf der Oberseite 15 der Leiterplatte 5 angeordnete Bedienelement 17 bildet zusammen mit dem auf der Unterseite 7 der Leiterplatte 5 angeordneten Busankoppler 9 sowie den Schnittstellen 2, 10 ein Kompaktmodul 20. Zum einfachen Anschluss des Kompaktmoduls 20 an das Unterputzmodul 11 ist die Schnittstelle 10 standardisiert. Über die Schnittstelle 10 ist auch das Unterputzmodul 11 mit dem Installationsbus 1 verbunden.

Aufgrund der standardisierten Schnittstelle 10 können - im Sinne eines Baukastensystems - verschiedene Kompaktmodule 20, beispielsweise mit unterschiedlichen Bedienelementen 17, sowie Unterputzmodule 11, beispielsweise mit unterschiedlichen Lastaktoren 12, auf einfache Weise in einem Installationsgerät 3 gekoppelt werden.

## Patentansprüche

1. Installationsgerät mit einem Busankoppler (9) zum Datenaustausch über einen Installationsbus (1) und mit einem Bedienelement (17) sowie mit einem Unterputzmodul (11), wobei eine erste Schnittstelle (2) zum Anschluss des Busankopplers (9) an den Installationsbus (1) sowie eine zweite Schnittstelle zum Anschluss an das Unterputzmodul (11) vorgesehen ist, **dadurch gekennzeichnet, dass** der Busankoppler (9) mit dem Bedienelement (17) zu einem als zweiseitig bestückte Leiterplatte (5) ausgeführten Kompaktmodul (20) zusammengefasst ist, wobei auf der einen Seite (15) ein Bauteil (16) des Bedienelementes (17) und auf der anderen Seite (7) ein Bauteil (8) des Busankopplers (9) angeordnet ist.

2. Installationsgerät nach Anspruch 1, **gekennzeichnet durch** einen Busankoppler (9) zur bidirektionalen Datenübertragung.

3. Installationsgerät nach Anspruch 1 oder 2, **dadurch gekennzeichnet, dass** das Unterputzmodul (11) einen Lastaktor (12) aufweist.

4. Installationsgerät nach einem der Ansprüche 1 bis 3, **dadurch gekennzeichnet, dass** das Unterputzmodul (11) einen Binäreingang (13) aufweist.

5. Installationsgerät nach einem der Ansprüche 1 bis 4, **dadurch gekennzeichnet, dass** die zweite Schnittstelle (10) zum Unterputzmodul (11) standardisiert ist.

6. Installationsgerät nach einem der Ansprüche 1 bis 5, **dadurch gekennzeichnet, dass** auf der Bedienelementseite (15) der Leiterplatte (5) ein mechanisches Koppelelement (18) angeordnet ist.

## Claims

1. Installation apparatus with a bus coupler (9) for the exchange of data via an installation bus (1) and with an actuator (17) and a built-in module (11), a first interface (2) thereof provided for the connection of the bus coupler (9) to the installation bus (1) and a second interface for connection to the built-in module (11), **characterised in that** the bus coupler (9) together with the actuator (17) is fastened to a compact module (20) designed as a printed circuit board (5) equipped on both sides with components, a component (16) of the actuator (17) being arranged on one side (15) and a component (8) of the bus coupler (9) on the other side (7).

2. Installation apparatus according to claim 1, **characterised by** a bus coupler (9) for bidirectional transmission of data.

3. Installation apparatus according to claims 1 or 2, **characterised in that** the built-in module (11) has a load actuator (12).

4. Installation apparatus according to one of claims 1 to 3, **characterised in that** the built-in module (11) has a binary input (13).

5. Installation apparatus according to one of claims 1 to 4, **characterised in that** the second interface (10) to the built-in module (11) is standardised.

6. Installation apparatus according to one of claims 1 to 5, **characterised in that** a mechanical coupler element (18) is arranged on the actuator side (15) of the printed circuit board (5).

## Revendications

1. Appareil d'installation ayant un connecteur de bus (9) pour l'échange de données par l'intermédiaire d'un bus d'installation (1) et un élément de commande (17) ainsi qu'un module encastré (11), une première interface (2) étant prévue pour le raccordement du connecteur de bus (9) au bus d'installation (1) et une deuxième interface étant prévue pour le raccordement au module encastré (11),
**caractérisé par le fait que** le connecteur de bus (9) est réuni à l'élément de commande (17) en un module compact (20) réalisé comme une carte (5) à circuits imprimés sur deux faces, un composant (16) de l'élément de commande (17) étant disposé d'un côté (15) et un composant (8) du connecteur de bus (9) étant disposé de l'autre côté (7).

2. Appareil d'installation selon la revendication 1, **caractérisé par** un connecteur de bus (9) pour la transmission bidirectionnelle de données.

3. Appareil d'installation selon la revendication 1 ou 2, **caractérisé par le fait que** le module encastré (11) comporte un actionneur de charge (12).

4. Appareil d'installation selon l'une des revendications 1 à 3, **caractérisé par le fait que** le module encastré (11) comporte une entrée binaire (13).

5. Appareil d'installation selon l'une des revendications 1 à 4, **caractérisé par le fait que** la deuxième interface (10) avec le module encastré (11) est normalisée.

6. Appareil d'installation selon l'une des revendications 1 à 5, **caractérisé par le fait qu'**un élément connecteur mécanique (18) est disposé du côté formant élément de commande (15) de la carte à circuits imprimés (5).
